# EUROPÄISCHE PATENTSCHRIFT

(11) **EP 0 519 200 B1**
(45) Veröffentlichungstag und Bekanntmachung des Hinweises auf die Patenterteilung: **07.12.1994**
(21) Anmeldenummer: 92107918.2
(22) Anmeldetag: 12.05.1992
(51) Int. Cl.: H05K 3/34

(54) **Verbindung von LLCCC-Bauelementen für die Raumfahrtelektronik**
Connection of LLCCC structural elements for the space electronics
Connexion d'éléments structurals LLCCC pour l'électronique spéciale

(30) Priorität: 15.06.1991 DE 4119741
(43) Veröffentlichungstag der Anmeldung: 23.12.1992
(73) Patentinhaber: Daimler-Benz Aerospace Aktiengesellschaft, 81663 München (DE)
(72) Erfinder: Rösel, Helmut, W-8150 Holzkirchen (DE); Eck, Martin, W-8011 Egmating (DE)

(56) Entgegenhaltungen:
- EP-A- 0 268 953
- DE-A- 3 834 147

## Beschreibung

Die Erfindung bezieht sich auf ein Verfahren zur Herstellung einer elektrischen Verbindung von LLCCC-Bauelementen auf Leiterplatten gemäß dem Gattungsbegriff des Anspruchs 1.

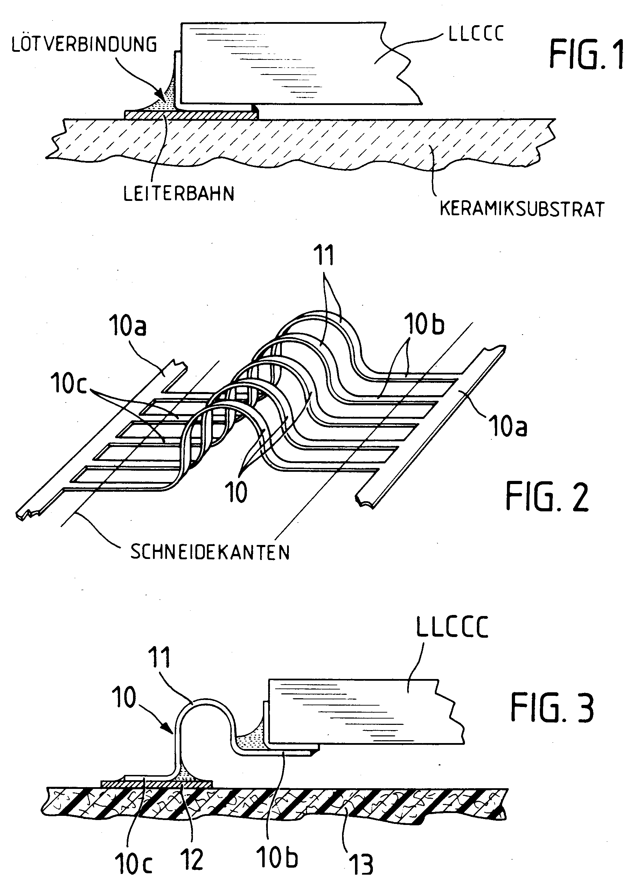

Der Einsatz von LLCCC-Bauelementen (Leadless Ceramic Chip Carrier) in der Raumfahrttechnik ist aufgrund der stark unterschiedlichen physikalischen Eigenschaften von Bauteil und Leiterplatte bisher nur auf Keramiksubstrate oder Spezialsubstrate mit angepaßten Ausdehungskoeffizienten möglich. Diese oberflächenmontierbaren integrierten Schaltkreise befinden sich in einem hermetisch dichten Keramikgehäuse, welche keine flexiblen Anschlüsse mehr haben und die vielfache Kontaktierung - bis zu 68 Anschlüsse - zum Keramiksubstrat muß über Lötflächen hergestellt werden. In der Figur 1 ist die Standardverbindung für LLCCC-Bauelemente beim bisherigen Stand der Technik aufgezeigt. Für die Verwendung solcher Bauelemente auf Leiterplatten in der Raumfahrttechnik ist diese Verbindungstechnik jedoch nicht ausreichend zuverlässig, da die auftretenden Temperaturwechselbelastungen zu große Ausdehnungsprobleme aufwerfen.

Ein weiteres gattungsgemäßes Verfahren ist EP-A-0 268 953 zu entnehmen.

Der vorliegenden Erfindung liegt die Aufgabe zugrunde, ein Verfahren der eingangs genannten Art aufzuzeigen, mit dem LLCCC-Bauelemente auch für die Raumfahrtelektronik einsetzbar sind und daß die dort auftretenden hohen Temperaturbelastungen auf diese Bauelemente zuverlässig eliminiert werden.

Diese Aufgabe wird durch die im Anspruch 1 aufgezeigten Maßnahmen in überraschend zuverlässiger Weise gelöst. In den Unteransprüchen sind Ausgestaltungen und Weiterbildungen angegeben und in der nachfolgenden Beschreibung ist ein Ausführungsbeispiel erläutert. Die Figuren der Zeichnung ergänzen diese Erläuterungen. Es zeigen:
- Fig. 1: ein Schemabild der Standardverbindung für LLCCC-Bauelemente nach dem Stand der Technik,
- Fig. 2: eine perspektivische Ansicht eines Teilstückes von ausgeätzten Verbindungselemente gemäß dem vorgeschlagenen Herstellungsverfahrens,
- Fig. 3: ein Schemabild (Querschnitt) der vorgeschlagenen Verbindungstechnik für die Raumfahrtverwendung von LLCCC-Bauelementen,
- Fig. 4: eine Ni-Folie mit den Verbindungselementen nach der galvanischen Verzinnung.

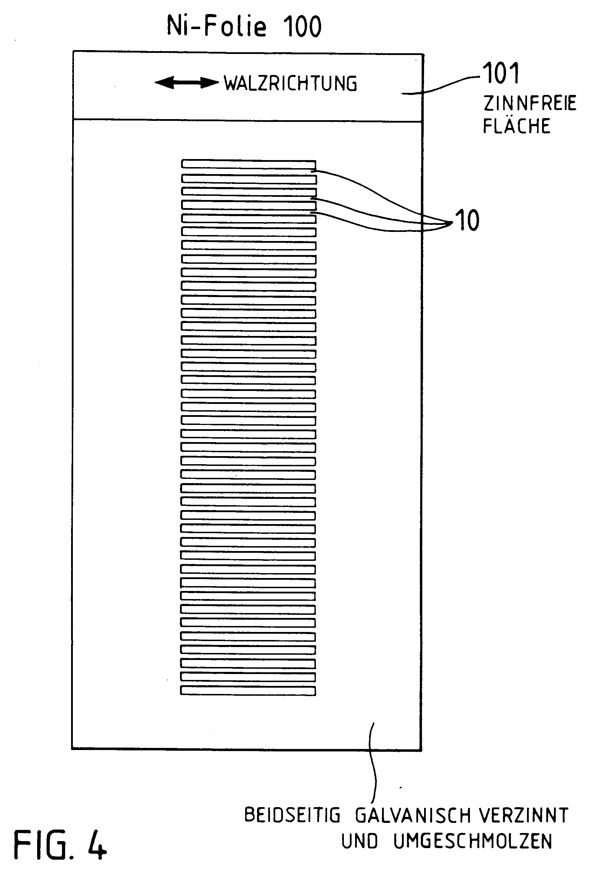

In der Raumfahrttechnik werden heute Epoxid-Glasfasergewebeplatten als Basismaterial für Leiterplatten verwendet. Um nun auf solchen Leiterplatten auch LLCCC-Bauelemente auflöten zu können und eine elektrische Verbindung herzustellen, wird vorgeschlagen aus einer beidseitig 10 bis 15 µ stark mit Sn60Pb galvanisch verzinnten Ni-Folie 100 Verbindungselemente 10 auszuätzen. Wie aus der Fig. 4 ersichtlich, bleibt ein Randstreifen 101 der Folie 100 unverzinnt, um an ihm die effektive Verzinnungsstärke messen und die Walzrichtung feststellen zu können.

Anschließend werden - wie die Figur 2 veranschaulicht - die Verbindungselemente in ihrem mittleren Bereich mit einer halbkreisförmigen Wölbung oder Biegung 11 versehen. In dem gezeigten Ausführungsbeispiel ist der Radius dieser Biegung 11 - wie überhaupt alle Dimensionierungen in der Zeichnung - vergrößert dargestellt. In Wirklichkeit beträgt hier dieser Radius z.B. 0,5mm. Nach der Erstellung dieser Biegung werden die Verbindungselemente einseitig auf Länge geschnitten, das heißt einer der Querstege 10a - wie dargestellt - wird an der durch die gewünschte Elementenlänge bestimmten Stelle abgeschnitten.

Die einseitig noch durch den anderen Quersteg 10a miteinander verbundenen Verbindungselemente 10 werden mit dem LLCCC-Bauelement einzeln verlötet. Nach dieser Verlötung wird nun der andere Quersteg 10a an der erforderlichen Steglänge abgetrennt und die freien Enden der nun am LLCCC-Bauelement durch die vorangegangene Verlötung in ihrer Lage fixierten Verbindungselemente 10 werden auf der Leiterbahn 12 der Leiterplatte 13 verlötet und so die elektrische Verbindung von Bauelement und Leiterplatte hergestellt.

Durch dieses Verfahren werden nun die bisherigen Ausdehnungsprobleme durch die hohen Temperaturwechselbelastungen in der Raumfahrt eliminiert und so die Verwendung von LLCCC-Bauelementen in der Raumfahrttechnik ermöglicht. Aber noch weitere Vorteile bietet das vorgeschlagene Verfahren, nämlich eine gute optische Kontrolle der Lötstellen, außerdem lassen sich die aufgelöteten Bauteile leicht und absolut unproblematisch auswechseln. Die Lötstellen müssen praktisch bei Vibrationen und Temperaturwechselbelastungen keine besonderen Belastungen mehr aufnehmen und letztlich wird durch dieses Verfahren das Einsatzspektrum von hochintegrierten Schaltkreisen wesentlich erweitert.

## Patentansprüche

1. Verfahren zur Herstellung einer elektrischen Verbindung von oberflächenmontierbaren integrierten Schaltkreisen, sogenannten LLCCC-Bauelementen (Leadless Ceramic Chip Carrier) in einem hermetisch dichten Keramikgehäuse, durch Auflöten auf Leiterplatten über Verbindungselemente, **dadurch gekennzeichnet**, daß
a) die Verbindungselemente (10) aus einer beidseitig galvanisch verzinnten Ni-Folie (100) in entsprechender Länge und Breite unter Beibehaltung eines beidseitigen Quersteges (10a) ausgeätzt werden,
b) anschließend im mittleren Bereich ihrer Längsausdehnung mit einer halbkreisförmigen Biegung (11) versehen werden,
c) dann einer der beiden Querstege (10a) abgeschnitten wird,
d) die Verbindungselemente (10) mit ihren freien Enden (10b) an dem LLCCC-Bauelement verlötet werden,
e) und anschließend der andere Quersteg (10a) von den Verbindungselementen (10) abgeschnitten und durch Verlötung der Endflächen (10c) auf der Leiterbahn (12) der Leiterplatte (13) die Verbindung des LLCCC-Bauelementes mit letzterer hergestellt wird.

2. Verfahren nach Anspruch 1, **dadurch gekennzeichnet**, daß die Ni-Folie (100) zur Herstellung der Verbindungselemente (10) 10 bis 15 µm stark beidseitig mit Sn60Pb verzinnt und umgeschmolzen wird.

3. Verfahren nach den Ansprüchen 1 und/oder 2, **dadurch gekennzeichnet**, daß die Ni-Folie einen Randstreifen (101) aufweist, der von der Verzinnung ausgenommen ist.

## Claims

1. Process for making an electrical connection of surface-mounted integrated circuits, so-called LLCCC elements (leadless ceramic chip carriers) in a hermetically sealed ceramic housing by soldering conductor plates over connecting elements, **characterised in that**
a) the connecting elements (10) are etched from a Ni-foil (100), which is electro-tinned on both sides, of respective length and width, whilst maintaining a transverse web (10a) on both sides;
b) they are then provided with a semi-circular curvature (11) in the middle area of their longitudinal extent;
c) then one of the two transverse webs (10a) is cut off;
d) the connecting elements (10) are with their free ends (10b) soldered onto the LLCCC element; and
e) the other transverse web (10a) is then cut off the connecting elements (10), and the connection between the LLCCC element and the latter is made by soldering the end surfaces (10c) onto the conducting strip (12) of the conductor plate (13).

2. Process according to claim 1, **characterised in that** the connecting elements (10) are made by tinning the Ni-foil on both sides with Sn60Pb between 10 and 15 µm thick and remelted.

3. Process according to claims 1 and/or 2, **charac****terised in that** the Ni-foil comprises an edge strip (101) which is not tinned.

## Revendications

1. Procédé d'établissement d'une connexion électrique de circuits intégrés à montage en surface dits composants LLCCC (Leadless Ceramic Chip Carrier = porte-puce à souder) dans un boîtier en céramique hermétiquement étanche, par soudage sur des plaques de circuits en passant par des éléments de connexion, caractérisé par le fait que
(a) les éléments de connexion (10) sont découpés par voie chimique dans une feuille de Ni (100) étamée par voie électrolytique sur ses deux faces, avec une longueur et une largeur appropriées, avec conservation d'une traverse (10a) sur les deux côtés,
(b) les éléments de connexion (10) sont ensuite munis dans la zone médiane de leur longueur d'un cintrage (11) semi-circulaire,
(c) l'une des deux traverses (10a) est alors sectionnée,
(d) les éléments de connexion (10) sont soudés par leurs extrémités libres (10b) sur le composant LLCCC,
(e) et ensuite l'autre traverse (10a) est sectionnée des éléments de connexion (10) et par soudage des surfaces d'extrémités (10c) des éléments de connexion (10) sur la bande conductrice (12) de la plaque de circuit (13), la connexion du composant LLCCC avec ladite plaque est établie.

2. Procédé suivant la revendication 1, caractérisé par le fait que la feuille de Ni (100) pour la' fabrication des éléments de connexion (10) est soumise sur les deux faces à un étamage à l'aide de Sn60Pb sur une épaisseur de 10 à 15 µm et à une fusion.

3. Procédé suivant les revendications 1 et/ou 2 , caractérisé par le fait que la feuille de Ni présente une bande marginale (101) qui n'est pas soumise à l'étamage.
